Europäisches Patentamt

European Patent Office

Office européen des brevets

(19)

(11) Veröffentlichungsnummer: **0 021 085**
**B1**

(12) # EUROPÄISCHE PATENTSCHRIFT

(45) Veröffentlichungstag der Patentschrift: **11.04.84**

(21) Anmeldenummer: **80102972.9**

(22) Anmeldetag: **28.05.80**

(51) Int. Cl.³: **H 03 F 3/45**, H 03 G 1/00, H 03 G 3/10

(54) **Monolithisch integrierbarer Transistorverstärker.**

(30) Priorität: **15.06.79 DE 2924171**

(43) Veröffentlichungstag der Anmeldung:
**07.01.81 Patentblatt 81/1**

(45) Bekanntmachung des Hinweises auf die Patenterteilung:
**11.04.84 Patentblatt 84/15**

(84) Benannte Vertragsstaaten:
**FR GB IT**

(56) Entgegenhaltungen:
**DE - A - 1 190 052**
**US - A - 3 843 934**
**US - A - 4 146 844**

**IEEE JOURNAL OF SOLID STATE CIRCUITS,**
**Band SC-3, Nr. 4, Dezember 1968 New York US**
**B. GILBERT: "A new wide-band amplifier**
**technique", Seiten 353-365**

(73) Patentinhaber: **SIEMENS AKTIENGESELLSCHAFT**
**Berlin und München Wittelsbacherplatz 2**
**D-8000 München 2 (DE)**

(72) Erfinder: **Fenk, Josef, Dipl.-Ing.**
**Deutenhauserstrasse 10**
**D-8057 Eching/Ottenburg (DE)**

Courier Press, Leamington Spa, England.

Monolithisch integrierbarer Transistorverstärker

Die Erfindung betrifft einen monolithisch integrierbaren Transistorverstärker mit vier einander gleichen Transistoren, die über ihre Emitterelektroden paarweise unter Entstehung zweier Differenzverstärker zusammengefaßt sind, bei dem die Emitter der beiden Differenzverstärker in übereinstimmender Weise an das eine Versorgungspotential und ihre Kollektoren in übereinstimmender Weise an das andere Versorgungspotential angeschaltet sind, bei dem dabei der Basisanschluß des ersten Transistors im ersten Differenzverstärker sowie der Basisanschluß des zweiten Transistors im zweiten Differenzverstärker über die Reihenschaltung zweier Widerstände miteinander verbunden und jeweils als eine Signaleingangsklemme verwendet sind, bei dem außerdem der Kollektor des ersten Transistors im ersten Differenzverstärker zusammen mit dem Kollektor des ersten Transistors im zweiten Differenzverstärker eine erste Signalausgangsklemme sowie der Kollektor des zweiten Transistors im ersten Differenzverstärker zusammen mit dem Kollektor des zweiten Transistors im zweiten Differenzverstärker eine zweite Signalausgangsklemme bilden und bei dem schließlich der Basisanschluß des zweiten Transistors im ersten Differenzverstärker sowie der Basisanschluß des ersten Transistors im zweiten Differenzverstärker miteinander verbunden sind.

Eine Transistorverstärkerschaltung dieser Art ist in der britischen Patentschrift 1 339 597 beschrieben, die sich jedoch wegen des Vorhandenseins von Kondensatoren für eine monolithische Integration nicht besonders eignet und auch in weiterer Beziehung noch verbesserungsbedürftig ist. Als weiterer Stand der Technik kann das Buch von U. Tietze und Ch. Schenk "Halbleiter-Schaltungstechnik" (1978), S. 59, genannt werden.

Es ist Aufgabe der Erfindung, einen monolithisch integrierbaren Transistorstromverstärker anzugeben, mit dessen Hilfe im Vergleich zu den bekannten emittergekoppelten Differenzstufen zwar ein erhöhter Stromverbrauch erforderlich ist, bei dem aber andererseits eine diesem Stromverbrauch entsprechende erhöhte Aussteuerfähigkeit gewährleistet ist. So ist zum Beispiel bei doppeltem Stromaufwand auch die doppelte Aussteuerfähigkeit gegeben. Um dasselbe zu leisten, mußten die bekannten Verstärker mit aufwendigen Regelschaltungen versehen werden, die außerdem bei monolithischer Darstellung zu erheblichen parasitären Substratströmen und außerdem zu einem so hohen Regelstrombedarf führten, der in keinem Verhältnis mehr zu der erreichten Aussteuerfähigkeit stand. Im einzelnen ist hierzu folgendes festzustellen:

Die Signalverarbeitung in integrierten Verstärken wird bevorzugt in symmetrischer Form durchgeführt. Der lineare Bereich einer Differenzstufe liegt dabei bei ca. $2 \cdot U_T$, wobei $U_T$ die Temperaturspannung ist. Sie kann durch Emitterwiderstände um den Betrag des Spannungsabfalls an diesen Widerständen erhöht werden. Für Schaltungsanwendungen zur Verstärkungsregelung kann man zum Beispiel als Dioden geschaltete Transistoren im Emitterzweig von Differenzstufen einsetzen. Damit erreicht man im Vergleich zu den normalen emittergekoppelten Differenzstufen ohne Gegenkopplung ebenfalls eine merklich erhöhte Aussteuerfähigkeit. Jedoch führt ein solches Vorgehen in einer monolithisch integrierten Halbleiterschaltung dazu, daß durch den Betrieb der soeben angegebenen Strukturen im Restspannungsbereich der komplementäre Substrattransistor aktiviert wird, was zu einem überproportionalen Regelstrombedarf beziehungsweise bei festgehaltenem Regelstrom zu Streuungen der Verstärkung führt. Da der Nutzregelstrom in den aktiven Teil der Regelschaltung gelangt, kommt es außerdem zu einer Änderung des Arbeitspunktes der Differenzstufe sowie zu einer unerwünschten Änderung der Kollektorbetriebsspannung.

Andererseits kann man den Gegenkopplungswiderstand im Emitter der Differenzstufe durch einen Transistor, der im Restspannungsbereich betrieben wird, kurzschließen, was aber ebenfalls zu unbefriedigenden Ergebnissen führt. Schließlich kann man für die Gegenkopplung einen Diodenring einsetzen, wodurch der negativ Einfluß von Substratströmen und die unerwünschte Änderung der Kollektorbetriebsspannung, aber nicht — ebenso wie bei den anderen angedeuteten Möglichkeiten — der überhöhte Aufwand an Regelstrom vermieden werden kann. Die vorliegende Erfindung befaßt sich mit der Überwindung der genannten Probleme.

Hierzu wird gemäß der Erfindung ein der eingangs gegebenen Definition entsprechender Transistorverstärker derart ausgestaltet, daß die Emitter der beiden Transistoren des ersten Differenzverstärkers sowie die Emitter der beiden Transistoren des zweiten Differenzverstärkers jeweils nur über einen gemeinsamen und in bekannter Weise entweder als Widerstand oder als Stromquelle ausgebildeten Schaltungsteil an das eine Versorgungspotential angeschlossen sind, daß außerdem der Basisanschluß des zweiten Transistors des ersten Differenzverstärkers und der Basisanschluß des ersten Transistors des zweiten Differenzverstärkers unter Verwendung einer Widerstandsanordnung mit einer Klemme für ein Referenzsignal verbunden sind und an diese Klemme außerdem der gemeinsame Verbindungspunkt der beiden die Verbindung zwischen dem Basisanschluß des ersten Transistors im ersten Differenzverstärker mit dem Basisanschluß des zweiten Transistors im zweiten Differenzverstärker bildenden Widerstände angeschlossen ist, und daß schließlich der Emitter der beiden Transistoren im ersten Differenzverstärker mit den Emittern der beiden Transistoren des zweiten Differenzverstärkers über einen Widerstand verbunden sind.

Damit hat man eine regelbare Schaltungs-anordnung, welche bei gleicher Aussteuer-fähigkeit die durch parasitäre Ströme gegebenen Nachteile der bekannten Verstärker vermeidet. Sie reduziert außerdem den Regelstrombedarf um den Faktor der Stromverstärkung und vermeidet eine nachteilige Arbeitspunktsverschiebung der Kollektorspannung. Außerdem kann die Stufe zur Regelung immer mit der gleichen Kollektor-Emitterspannung betrieben werden. Gegenüber einer Verstärkerschaltung nach der GB—Patentschrift 1 339 597 wird durch das Fehlen der Gegenkopplungswiderstände bei den Emittern des ersten und des zweiten Differenzverstärkers eine höhere Grundverstärkung erreicht. Außerdem führt die Anwesenheit des Widerstandes zwischen dem Emitteranschluß der beiden Transistoren des ersten Differenzverstärkers und dem Emitteranschluß der beiden Transistoren des zweiten Differenzverstärkers bei der erfindungsgemäßen Schaltung neben der Verbesserung der Grundverstärkung vor allem zu einer Festlegung des Regelbereichs — Endwerts.

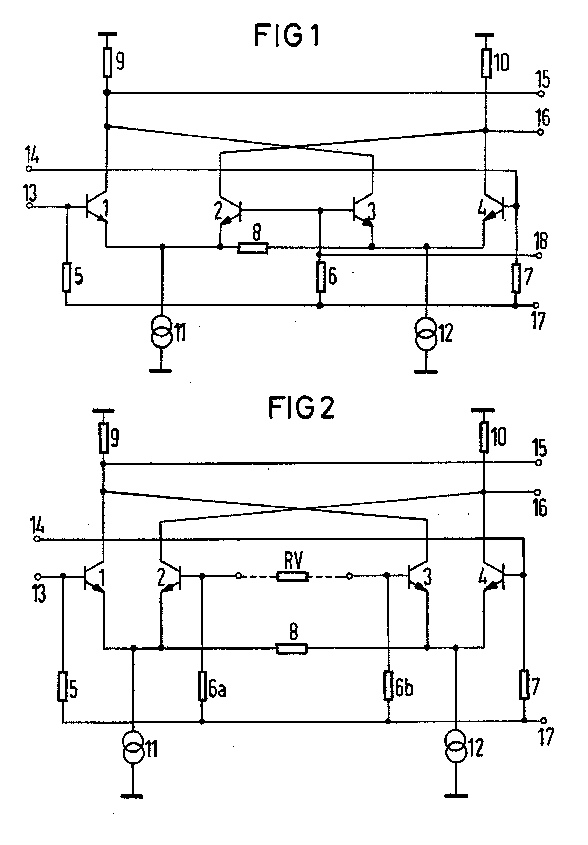

Bei dem erfindungsgemäßen Transistorverstärker wird also eine emittergekoppelte Differenzstufe, deren Gegenkopplungswiderstand R je nach Regelumfang Werte bis R=∞ aufweisen kann, so mit einer basisgekoppelten Differenzstufe zusammengeschaltet, daß je ein Emitter der basisgekoppelten Differenzstufe mit je einem Emitter der emittergekoppelten Differenzstufe verbunden ist. Wesentlich ist, daß die Kollektoren entsprechend der Phase des Kollektorsignals paarweise zusammengefaßt sind und an zwei Ausgängen liegen, wie die aus Fig. 1 bzw. Fig. 2 ersichtliche Ausgestaltung der Erfindung zeigt. Am Basisanschluß der basisgekoppelten Differenzstufe kann die Verstärkungsregelung entweder durch Stromverteilungssteuerung (Fig. 1) oder durch Gegenkopplungsregelung (Fig. 2) vorgenommen werden.

Die Erfindung wird nun an Hand der Fig. 1 und 2 näher beschrieben:

Zwischen den beiden Eingangsanschlüssen 13, 14 liegt das symmetrische Eingangssignal. Die Transistoren 1 und 4 sind die Eingangstransistoren, deren Emitterverkopplung durch den Gegenkopplungswiderstand 8 festgelegt wird. Transistor 2 und Transistor 3 stellen eine basisgekoppelte Differenzstufe dar, die durch eine Steuerleitung 18 bei der in Fig. 1 ersichtlichen Ausgestaltung in ihrem Arbeitspunkt und somit in der Verstärkung eingestellt werden kann. Maximale Verstärkung erhält man dann, wenn der Strom durch alle vier Transistoren 1, 2, 3 und 4 gleiche Beträge aufweist und der Gegenkopplungswiderstand 8 durch die symmetrisch wirksame Emittereingangsimpedanz von Transistor 3 und Transistor 4 auf den Wert

$$2\,(U_T/I_{E3,4})+(r_b)\beta)$$

reduziert wird, wobei

$U_T$=Temperaturspannung
$I_{E3,4}$=Emitterstrom
$r_b$=Basisbahnwiderstand
$\beta$=Wechselstromverstärkung in Emitter-schaltung

ist.

An die Emitter der Transistorpaare 1, 2 und 3, 4 ist entweder über je einen Vorwiderstand ein Gleichspannungspotential $V_{EE}$ oder der eine Pol einer Konstantstromquelle 11 beziehungsweise 12 angeschlossen. Der andere Anschluß der das Gleichspannungspotential $V_{EE}$ liefernden Spannungsquelle beziehungsweise der andere Pol der Konstantstromquelle 11 beziehungsweise 12 liegt über je einen Lastwiderstand 9 beziehungsweise 10 an den Kollektoren der Transistoren 1, 3 beziehungsweise 2, 4. Diese werden entsprechend der gewünschten Stufenverstärkung bemessen.

Entsprechend der oben gegebenen Definition der Erfindung sind die vier Transistoren 1, 2, 3 und 4 vom selben Typ, also entweder npn-Transistoren oder pnp-Transistoren. Der Emitter des Transistors 1 und der Emitter des Transistors 2 sind miteinander verbunden und werden entweder über einen Vorwiderstand mit dem ihrem Leitungstyp entsprechenden Betriebspotential $V_{GG}$ oder, wie in Fig. 1 und 2, mit dem einen Pol einer Konstantstromquelle 11 verbunden. Die Basis des Transistors 1 bildet den einen Signaleingang 13. Der Kollektor des Transistors 1 liegt am Signalausgang 15 und außerdem über den Lastwiderstand 9 am zweiten Betriebspotential $V_{CC}$ oder am anderen Pol der Konstantstromquelle 11.

Der Transistor 3 ist mit seinem Emitter mit dem Emitter des Transistors 4 verbunden. Beide Emitter werden entweder über einen Vorwiderstand an dasselbe Potential $V_{EE}$ gelegt, an welchem bereits die Emitter der Transistoren 1 und 2 angeschaltet sind. Oder es ist eine zweite Konstantstromquelle 12 vorgesehen, an deren einen Anschluß die Emitter der Transistoren 3 und 4 liegen. Im erstgenannten Fall liegt der Kollektor des Transistors 4 über einen Lastwiderstand 10 am zweiten Betriebspotential $V_{CC}$, im zweiten Fall über den Lastwiderstand 10 am zweiten Anschluß der Konstantstromquelle 12. Einzelheiten über den Aufbau von Konstantstromquellen sind zum Beispiel dem genannten Buch von Tietze-Schenk "Halbleiter-Schaltungstechnik" (1978), Seiten 53 bis 59 zu entnehmen.

Der Kollektor des Transistors 4 bildet die andere Ausgangsklemme 16 des Transistorverstärkers. Der Kollektor des Transistors 2 ist mit dem Kollektor des Transistors 4, der Kollektor des Transistors 1 mit dem Kollektor des Transistors 3 verbunden. Ferner liegt bei der Ausgestaltung gemäß Fig. 1 die Basis des Transistors 2 unmittelbar an der Basis des Transistors 3. Ferner sind die Emitter der Transistoren 1 und 2 über einen Gegenkopplungswiderstand 8 mit den Emittern der Transistoren 3 und 4 verbunden, wodurch die in der Definition der Erfindung erwähnte gemeinsame Verbindung zwischen den Emittern der vier Transistoren 1 bis 4 gegeben ist. Ferner ist ein durch ein Referenzpotential beziehungsweise Referenzsignal zu beaufschlagender Referenzeingang 17 vorgesehen, der über je einen Widerstand 5 beziehungsweise 6, beziehungsweise 7 mit der Basis des Transistors 1, beziehungsweise der Transistoren 2 und 3, beziehungsweise des Transistors 4 verbunden ist. Schließlich liegt die Basis des Transistors 4 an der zweiten Eingangsklemme 14 des Verstärkers.

In der Schaltungsanordnung gemäß Fig. 2 ist nicht, wie bei Fig. 1, die sogenannte Stromverteilungssteuerung, sondern die sogenannte Gegenkopplungsregelung gewählt. Hier ist die Verbindung zwischen den Basisanschlüssen der beiden Transistoren 2 und 3 durch ein die Regelung vermittelndes Schaltungsglied RV aufgetrennt, das zum Beispiel durch eine übliche Regelschaltung, wie zum Beispiel eine Regelschaltung mit zwei Dioden oder einem Diodenring, gegeben ist und dann die Verbindung zwischen den Basisanschlüssen des zweiten Transistors und des dritten Transistors, als der Transistoren 2 und 3, bildet. Die Basisanschlüsse der beiden Transistoren 2 und 3 sind hier jeweils durch einen Widerstand 6a bzw. 6b mit dem Referenzeingang 17 verbunden. Die minimale Verstärkung erhält man dann, wenn der Innenwiderstand des Schaltungsglieds $R_V$ gegen unendlich geht und wenn die Größe des Gegenkopplungswiderstands 8 die Verstärkung festlegt. Die maximale Verstärkung ist dann gegeben, wenn der Innenwiderstand des Schaltungsglieds $R_V$ gegen Null geht.

**Patentansprüche**

1. Monolithisch integrierbarer Transistorverstärker mit vier einander gleichen Transistoren, die über ihre Emitterelektroden paarweise unter Entstehung zweier Differenzverstärker zusammengefaßt sind, bei dem die Emitter der beiden Differenzverstärker in übereinstimmender Weise an das eine Versorgungspotential und ihre Kollektoren in übereinstimmender Weise an das andere Versorgungspotential angeschaltet sind, bei dem dabei der Basisanschluß des ersten Transistors (1) im ersten Differenzverstärker sowie der Basisanschluß des zweiten Transistors (4) im zweiten Differenzverstärker über die Reihenschaltung zweier Widerstände (5, 7) miteinander verbunden und jeweils als eine Signaleingangsklemme (13; 14) verwendet sind, bei dem außerdem der Kollektor des ersten Transistors (1) im ersten Differenzverstärker zusammen mit dem Kollektor des ersten Transistors (3) im zweiten Differenzverstärker eine erste Signalausgangsklemme (15) sowie der Kollektor des zweiten Transistors (2) im ersten Differenzverstärker zusammen mit dem Kollektor des zweiten Transistors (4) im zweiten Differenzverstärker eine zweite Signalausgangsklemme (16) bilden und bei dem schließlich der Basisanschluß des zweiten Transistors (2) im ersten Differenzverstärker sowie der Basisanschluß des ersten Transistors (3) im zweiten Differenzverstärker miteinander verbunden sind, dadurch gekennzeichnet, daß die Emitter der beiden Transistoren (1, 2) des ersten Differenzverstärkers sowie die Emitter der beiden Transistoren (3, 4) des zweiten Differenzverstärkers jeweils nur über einen gemeinsamen und in bekannter Weise entweder als Widerstand oder als Stromquelle ausgebildeten Schaltungsteil (11 bzw. 12) an das eine Versorgungspotential angeschlossen sind, daß außerdem der Basisanschluß des zweiten Transistors (2) des ersten Differenzverstärkers und der Basisanschluß des ersten Transistors (3) des zweiten Differenzverstärkers unter Verwendung einer Widerstandsanordnung (6; 6a, 6b) mit einer Klemme (17) für ein Referenzsignal verbunden sind und an diese Klemme (17) außerdem der gemeinsame Verbindungspunkt der beiden die Verbindung zwischen dem Basisanschluß des ersten Transistors (1) im ersten Differenzverstärker mit dem Basisanschluß des zweiten Transistors (4) im zweiten Differenzverstärker bildenden Widerstände (5, 7) angeschlossen ist und daß schließlich der Emitter der beiden Transistoren (1, 2) im ersten Differenzverstärker mit den Emittern der beiden Transistoren (3, 4) des zweiten Differenzverstärkers über einen Widerstand (8) verbunden sind.

2. Transistorverstärker nach Anspruch 1, dadurch gekennzeichnet, daß für die Verbindung zwischen der Klemme (17) für das Referenzsignal und dem Basisanschluß des zweiten Transistors (2) des ersten Differenzverstärkers sowie für die Verbindung zwischen der Klemme (17) für das Referenzsignal und dem Basisanschluß des ersten Transistors (3) des zweiten Differenzverstärkers ein beiden Verbindungen gemeinsamer Widerstand (6) vorgesehen ist (Fig. 1).

3. Transistorverstärker nach Anspruch 1 oder 2, dadurch gekennzeichnet, daß die miteinander verbundenen Anschlüsse der Basis des zweiten Transistors (2) des ersten Differenzverstärkers und der Basis des ersten Transistors (3) des zweiten Differenzverstärkers mit einer der Einstellung des Arbeitspunktes dienenden Steuerleitung (18) verbunden sind, (Fig. 1).

4. Transistorverstärker nach Anspruch 1, dadurch gekennzeichnet, daß sowohl der Basisanschluß des zweiten Transistors (2) des ersten Differenzverstärkers als auch der Basisanschluß des ersten Transistors (3) des zweiten Differenzverstärkers über je einen Widerstand (6a, 6b) an die Klemme (17) für das Referenzsignal gelegt ist und daß zwischen den Basisanschlüssen dieser beiden Transistoren ein eine Verstärkungsregelung vermittelndes Schaltungsglied (RV) vorgesehen ist, dessen einer Anschluß an der Basis des zweiten Transistors (2) des ersten Differenzverstärkers und dessen anderer Anschluß an der Basis des ersten Transistors (3) des zweiten Differenzverstärkers liegt (Fig. 2).

**Revendications**

1. Amplificateur à transistors intégrable monolithiquement comportant quatre transistors identiques qui sont réunis par paire, par l'intermédiaire de leurs électrodes d'émetteur, en formant deux amplificateurs différentiels, dans lequel les émetteurs des deux amplificateurs différentiels sont reliés de façon identique à un potentiel d'alimentation et leurs collecteurs sont reliés de façon identique à l'autre potentiel d'alimentation, dans lequel ce faisant la borne de base du premier transistor (1) dans le premier amplificateur différentiel ainsi que la borne de base du second transistor (4) dans le second amplificateur différentiel sont reliées l'une à l'autre par l'intermédiaire du circuit série de deux résistances (5, 7) et sont respectivement utilisées comme borne d'entrée de signaux (13; 14), dans lequel en outre le collecteur de premier transistor (1) dans le premier amplificateur différentiel forme, conjointement avec le collecteur du premier transistor (3) dans le second amplificateur différentiel, une première borne de sortie de signaux (15), et le collecteur du second transistor (2) dans le premier amplificateur différentiel forme, conjointement avec le collecteur du second transistor (4) dans le second amplificateur différentiel, une seconde borne de sortie de signaux (16), et dans lequel enfin la borne de base du second transistor (2) dans le premier amplificateur différentiel ainsi que la borne de base du premier transistor (3) dans le second amplificateur différentiel sont reliées l'une à l'autre, caractérisé par le fait que l'émetteur des deux transistors (1, 2) du premier amplificateur différentiel ainsi que les émetteurs des deux transistors (3, 4) du second amplificateur différentiel sont respectivement reliés au premier potentiel d'alimentation uniquement par l'intermédiaire d'une partie du circuit (11 ou 12) commune et se présentant, de façon connue en soi, soit sous la forme d'une résistance soit sous la forme d'une source de courant, qu'en outre la borne de base du second transistor (2) du premier amplificateur différentiel et la borne de base du premier transistor (3) du second amplificateur différentiel sont reliées, en utilisant un agencement de résistance (6; 6a, 6b), à une borne (17) pour un signal de référence, et qu'à cette borne (17) est en outre relié le point de jonction commun des deux résistances (5, 7) formant la liaison entre la borne de base du premier transistor (1) dans le premier amplificateur différentiel et la borne de base du second transistor (4) dans le second amplificateur différentiel, et qu'enfin les émetteurs des deux transistors (1, 2) dans le premier amplificateur différentiel sont reliés aux émetteurs des deux transistors (3, 4) du second amplificateur différentiel par l'intermédiaire d'une résistance (8).

2. Amplificateur à transistors suivant la revendication 1, caractérisé par le fait que pour la liaison entre la borne (17) pour le signal de référence et la borne de base du second transistor (2) du premier amplificateur différentiel ainsi que pour la liaison entre la borne (17) pour le signal de référence et la borne de base du premier transistor (3) du second amplificateur différentiel, il est prévu une résistance (6) commune à ces deux liaisons (figure 1).

3. Amplificateur à transistors suivant la revendication 1 ou 2, caractérisé par le fait que les bornes, reliées l'une à l'autre, de la base du second transistor (2) du premier amplificateur différentiel et de la base du premier transistor (3) du second amplificateur différentiel sont reliées à un conducteur de commande (18) servant au réglage du point de fonctionnement (figure 1).

4. Amplificateur à transistors suivant la revendication 1, caractérisé par le fait qu'aussi bien la borne de base du second transistor (2) du premier amplificateur différentiel que la borne de base du premier transistor (3) du second amplificateur différentiel sont reliées, par l'intermédiaire d'une résistance respective (6a, 6b), à la borne (17) pour le signal de référence, et qu'entre les bornes de base de ces deux transistors est prévu un élément de circuit (RV) transmettant un réglage d'amplification, dont une borne est reliée à la base du second transistor (2) du premier amplificateur différentiel et dont l'autre borne est reliée à la base du premier transistor (3) du second amplificateur différentiel (figure 2).

**Claims**

1. A monolithically integratable transistor amplifier having four identical transistors combined in pairs by their emitter electrodes forming two differential amplifiers, wherein the emitters of the two differential amplifiers are connected to the one supply potential in corresponding fashion and their collectors are connected to the other supply potential in corresponding fashion, wherein the base electrode of the first transistor (1) in the first differential amplifier and the base electrode of the second transistor (4) in the second differential amplifier are mutually connected by the series connection of two resistors (5, 7) and used as respective signal input terminals (13; 14) wherein furthermore the collector of the first transistor (1) in the first differential amplifier together with the collector of the first transistor (3) in the second differential amplifier forms a first signal output terminal (15) and the collector of the second transistor (2) in the first differential amplifier together with the collector of the second transistor (4) in the second differential amplifier forms a second output terminal (16), and wherein finally the base electrode of the second transistor (2) in the first differential amplifier and the base electrode of the first transistor (3) in the second differential amplifier are mutually connected, characterised in that the emitters of the two transistors (1, 2) of the first differential amplifier and the emitters of the two transistors (3, 4) of the second differential amplifier are each connected to the one supply potential by respective common circuit elements (11 and 12) which are either a resistor or a current source of known type, and that furthermore the base electrode of the second transistor (2) of the first differential amplifier and the base electrode of the first transistor (3) of the second differential amplifier are connected to a terminal (17) for a reference signal via a resistor arrangement (6; 6a, 6b), together with the mutual connection point of the two resistors (5, 7) forming the connection between the base electrode of the first transistor (1) in the first differential amplifier and the base electrode of the second transistor (4) in the second differential amplifier, and that finally the emitters of the two transistors (1, 2) in the first differential amplifier are connected to the emitters of the two transistors (3, 4) of the second differential amplifiers by a resistor (8).

2. A transistor amplifier as claimed in Claim 1, characterised in that a resistor (6) common to both connections is provided between the terminal (17) for the reference signal and the base electrodes of the second transistor (2) of the first differential amplifier and of the first transistor (3) of the second differential amplifier, (Fig. 1).

3. A transistor amplifier as claimed in Claim 1 or 2, characterised in that the mutually connected base electrodes of the second transistor (2) of the first differential amplifier and of the first transistor (3) of the second differential amplifier are connected to a control line (18) which serves to adjust the operating point, (Fig. 1).

4. A transistor amplifier as claimed in Claim 1, characterised in that both the base electrode of the second transistor (2) of the first differential amplifier and the base electrode of the first transistor (3) of the second differential amplifier are connected to the terminal (17) for the reference signal by respective resistors (6a, 6b), and that between the base electrodes of these two transistors there is a circuit element (RV) which provides an amplification regulation and whose one contact is connected to the base of the second transistor (2) of the first differential amplifier and whose other contact is connected to the base of the first transistor (3) of the second differential amplifier (Fig. 2).

# FIG 1

# FIG 2